# EUROPEAN PATENT APPLICATION

(11) **EP 4 656 616 A1**
(43) Date of publication of application: **03.12.2025**
(21) Application number: 24763938.8
(22) Date of filing: 27.02.2024
(51) Int. Cl.: C04B 35/488, G01R 31/26, H01L 21/66

(54) **CERAMIC, PROBE GUIDANCE COMPONENT, PROBE CARD, AND SOCKET FOR PACKAGE INSPECTION**

(30) Priority: 02.03.2023 JP 2023031963
(71) Applicant: Ferrotec Corporation, Tokyo 103-0027 (JP)
(72) Inventor: YAMAGISHI, Wataru, Hakusan-shi, Ishikawa 924-0833 (JP); FUJITA, Akira, Hakusan-shi, Ishikawa 924-0833 (JP); MORI, Kazumasa, Hakusan-shi, Ishikawa 924-0833 (JP); ETO, Shunichi, Hakusan-shi, Ishikawa 924-0833 (JP)
(74) Representative: Isarpatent
(86) International application number: PCT/JP2024/007139
(87) International publication number: WO 2024/181459

(57) **Abstract**

A ceramic having a chemical composition containing, in terms of mass % on an oxide basis, 66.5% or more ZrO₂, and one or more selected from Y₂O₃, CaO, MgO, CeO₂, and HfO₂, a total of which is 10 to 30%, wherein a crystal structure of the ZrO₂ is cubic.

## Description

### TECHNICAL FIELD

The present invention relates to a ceramic, a probe guide component, a probe card, and a package test socket.

### BACKGROUND ART

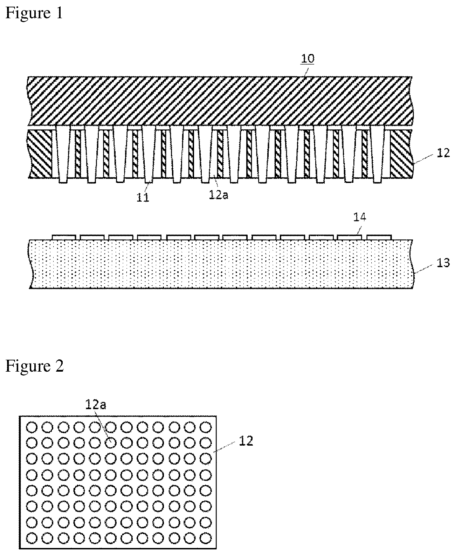

For example, a probe card is used in a test process of IC chips. Figure 1 shows a cross-sectional view illustrating the configuration of a probe card, and Figure 2 shows a top view illustrating the configuration of a probe guide. As shown in Figure 1 and Figure 2, a probe card 10 is a testing jig that includes needle-shaped probes 11 and a probe guide (probe guide component) 12 having a plurality of through-holes 12a into which the respective probes 11 are inserted. Additionally, a test of IC chips 14 is performed by bringing the plurality of probes 11 into contact with the IC chips 14 formed on a wafer 13.

Patent Document 1 discloses a ceramic whose main raw materials are, in mass%, 20.0 to 60.0% Si₃N₄ and 25.0 to 70.0 of ZrO₂. The ceramic disclosed in Patent Document 1 is excellent in strength, workability, and the like, and is therefore suitable for use in probe guides and the like.

### LIST OF PRIOR ART DOCUMENTS

### PATENT DOCUMENT

Patent Document 1: WO 2019/099370

### SUMMARY OF INVENTION

### TECHNICAL PROBLEM

Incidentally, in recent years, IC chips have been required to guarantee operations at high temperatures in products for automobiles and the like. It is because the current and voltage to be applied have been increased in terms of improving performance. Therefore, semiconductor tests at higher temperatures are performed. In such tests at higher temperatures, although the temperature of a wafer becomes high, the temperature of a probe card remains low. When the difference between the temperature of the material of the wafer and the temperature of the material of the probe guide is large at the time of a test, it can be said that the material of the wafer and the material of the probe guide are in an environment where the wafer material is prone to thermal expansion and the probe guide material is not prone to thermal expansion.

Then, in a case of a ceramic with a thermal expansion coefficient similar to that of the material of the wafer, such as the ceramic disclosed in Patent Document 1 described above, probes cannot be brought into contact with correct positions on IC chips. As a result, there is a problem that a proper test cannot be performed. This problem becomes evident in cases of IC chips using wafers with higher thermal expansion coefficient.

In addition, when high temperatures and stress are repeatedly applied to a probe card in an environment where test is performed, dimensional changes may occur, and a misalignment may occur between the positions of probes and the through-holes of a probe guide. As a result, there is also a problem that an operational failure occurs. Therefore, there is a demand for a ceramic that has a high thermal expansion coefficient and that can suppress dimensional changes.

Based on the above, an object of the present invention is to provide a ceramic that has a high thermal expansion coefficient and that can suppress dimensional changes.

### SOLUTION TO PROBLEM

The present invention has been made to solve the above-described problems, and the gist of the present invention includes a ceramic, a probe guide component, a probe card, and a package test socket as follows.

(1) A ceramic having a chemical composition containing,
   in terms of mass% on an oxide basis,
   66.5% or more ZrO₂, and
   one or more selected from Y₂O₃, CaO, MgO, CeO₂, and HfO₂, a total of which is 10 to 30%, wherein
   a crystal structure of the ZrO₂ is cubic.
(2) The ceramic according to (1) described above, wherein the chemical composition further contains,
   in terms of mass% on an oxide basis,
   Al₂O₃: 0 to 25%, and
   further contains, in terms of mass% on a nitride basis,
   Si₃N₄: 0 to 20%, and
   BN: 0 to 20%.
(3) The ceramic according to (1) described above, wherein the chemical composition further contains,
   in terms of mass% on an oxide basis,
   0 to 5% one or more selected from TiO₂, MoO₃, Ta₂O₅, Yb₂O₃, and LaO.
(4) The ceramic according to (2) described above, wherein the chemical composition further contains,
   in terms of mass% on an oxide basis,
   0 to 5% one or more selected from TiO₂, MoO₃, Ta₂O₅, Yb₂O₃, and LaO.
(5) The ceramic according to any of (1) to (4) described above, wherein a thermal expansion coefficient is 7.0 × 10⁻⁶/°C or more.
(6) The ceramic according to any of (1) to (4) described above, wherein a thermal conductivity is 10 W/m·K or less.
(7) The ceramic according to (5) described above, wherein a thermal conductivity is 10 W/m·K or less.
(8) A probe guide component including the ceramic according to any of (1) to (4) described above.
(9) A probe card including the probe guide component according to (8) described above.
(10) A package test socket including the ceramic according to any of (1) to (4) described above.

### ADVANTAGEOUS EFFECTS OF INVENTION

According to the present invention, it is possible to obtain a ceramic that has a high thermal expansion coefficient and that can suppress dimensional changes.

### BRIEF DESCRIPTION OF DRAWINGS

[Figure 1] Figure 1 is a cross-sectional view illustrating the configuration of a probe card.
[Figure 2] Figure 2 is a top view illustrating the configuration of a probe guide.
[Figure 3] Figure 3 is a diagram illustrating an example of XRD measurement results in identifying the crystal phase.
[Figure 4] Figure 4 is a schematic diagram of a processed surface in dimensional evaluation of the laser processability.

### DESCRIPTION OF EMBODIMENTS

The inventors investigated ceramics that were usable for a probe guide even when a wafer was at high temperature, and obtained the following findings.

(a) Since a probe guide does not directly contact a wafer and heat is conducted via, for example, a probe, the temperature is increased, but is lower than the temperature of the wafer. Therefore, even if the temperature is lower than that of the wafer, it is required to thermally expand as much as the wafer. The thermal expansion coefficient of a silicon wafer is about 2.6 × 10⁻⁶/°C. On the other hand, the thermal expansion coefficients of wafer materials such as SiC or GaN that can also be used at high temperatures, which have been used in recent years, are quite high and are about 4.0 to 6.0 × 10⁻⁶. Accordingly, it is preferable to have a thermal expansion coefficient higher than that of a wafer, specifically, a thermal expansion coefficient of 7.0×10⁻⁶/°C or more.
(b) In order to achieve a thermal expansion coefficient within the range described above, it is preferable to use a ceramic containing ZrO₂ as the main component. However, ZrO₂ is a substance that has any one of monoclinic, tetragonal, and cubic crystal structures, and the crystal structure changes due to phase transformation. When ZrO₂ contains a certain amount or more of tetragonal and monoclinic crystals, as the probe guide is used multiple times, dimensional changes will occur. This is because, in a usage environment where heating and stress load repeatedly occur, the crystal structure will change and will not return to its original dimensions when cooled. In addition, when a certain amount or more of tetragonal crystals are contained, a chemical reaction may occur with moisture or the like. Therefore, it is necessary for ZrO₂ to primarily have a cubic crystal structure.
(c) In order for ZrO₂ to have a cubic crystal structure, it is preferable to contain, for example, a certain amount of a stabilizer such as Y₂O₃. Moreover, a sintering aid may be contained as needed.

One embodiment of the present invention has been made based on the findings described above. Hereinafter, each of the requirements (the chemical composition, the crystal structure, and the like) for a ceramic of the present embodiment will be described in detail. Note that, in descriptions of contents, unless otherwise specified, "%" means "mass%."

### 1. ZrO₂

### 1-1. Mass Fraction of ZrO₂

ZrO₂ is effective in imparting a high thermal expansion coefficient to ceramics. Therefore, the ceramic of the present embodiment contains, in terms of mass% on an oxide basis, 66.5% or more ZrO₂. The content of ZrO₂ is preferably 70.0% or more, and preferably 80.0% or more.

Although the upper limit of the content of ZrO₂ is not particularly limited, in order to obtain a desired amount of cubic ZrO₂, the content of ZrO₂ is preferably 90.0% or less in terms of mass% on an oxide basis.

### 1-2. Crystal Structure of ZrO₂

ZrO₂ (also referred to as zirconium oxide, "zirconia".) has a monoclinic, tetragonal, or cubic crystal structure. Generally, in order to impart high strength to ceramics, tetragonal ZrO₂ with a few percent of oxide in solid solution is preferably used. However, even if the temperature is a low temperature, for example, a temperature less than 200°C, when this tetragonal ZrO₂ is subjected to the low temperature for a long time, a transition to a monoclinic phase occurs. The dimensions of the ceramic are changed in this phase transition. This phase transition proceeds at, for example, 40°C or more, and proceeds more significantly at 150°C or more.

Accordingly, when such a ceramic is used for a probe guide, as the temperature range used becomes higher, the positions of a plurality of through-holes and/or slits into which probes are inserted may be shifted, and insertion of the probes may be inhibited. Thus, it is preferable that ZrO₂ be cubic ZrO₂ which does not undergo a phase transition, that is, dimensional changes, at operating temperatures.

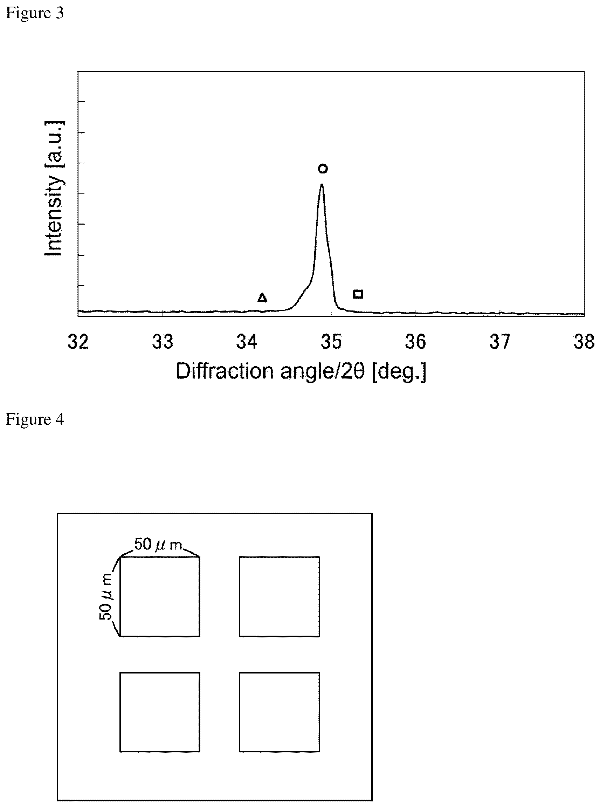

Therefore, in the ceramic of the present embodiment, the crystal structure of ZrO₂ described above is cubic. Here, whether "the crystal structure of ZrO₂ is cubic" is determined in the following procedures. Specifically, peak intensity is measured by XRD, and as illustrated in Figure 3, the peak intensity of each crystal phase (monoclinic, cubic, and tetragonal) on the (200) plane of ZrO₂ is obtained. In Figure 3, 34.2 degrees indicated by Δ is the monoclinic peak, 34.9 degrees indicated by ○ is the cubic peak, and 35.3 degrees indicated by □ is the tetragonal peak. In the present application, considering ease of identification of the crystal phase, determination is performed based on the intensity at a diffraction angle 2θ of about 35 degrees. In addition, when the sum of the three peak intensities is 100%, in a case where the cubic peak intensity is 80% or more, it is said that the crystal structure of ZrO₂ is cubic. Note that, in order to remove noise during measurement, the peak intensity may be obtained by drawing a baseline in the range of diffraction angle 2θ of 32 to 38 degrees.

### 2. Al₂O₃: 0 to 25%

The ceramic of the present embodiment may contain Al₂O₃ as needed, in addition to ZrO₂ described above. Al₂O₃ may be used as a sintering aid. In addition, it may impart high strength, for example, bending strength, to ceramics. In addition, the laser processability may be improved. However, when Al₂O₃ is excessively contained, the laser processability is decreased. Therefore, the content of Al₂O₃ is preferably 25% or less, and more preferably 20% or less in terms of mass% on an oxide basis. The content of Al₂O₃ is further preferably 15% or less in terms of mass% on an oxide basis.

On the other hand, in order to obtain the effects described above, the content of Al₂O₃ is preferably 0.5% or more, preferably 3% or more, more preferably 5% or more, and further preferably 10% or more in terms of mass% on an oxide basis.

Note that the content of each compound is calculated based on the amount of element measured by ICP atomic emission spectroscopy, which will be described below. In the case of this analytical method, it is not possible to distinguish between, for example, Al₂O₃ and AlN, both of which contain the same Al. Therefore, the content in the case where the total amount of Al is converted into Al₂O₃, which is an oxide, is theoretically calculated. This value means expression in terms of mass% on an oxide basis. Accordingly, for example, even when AlN is used for a raw material without using Al₂O₃, and AlN is contained in an end product ceramic, the Al content in the AlN is converted into and calculated as the content of Al₂O₃, which is an oxide.

In the ceramic of the present embodiment, there is a possibility that, for example, Al₂O₃ and AlN are contained as compounds that contain Al, but in addition to these compounds, other compounds containing Al may be contained as long as the effects of the ceramic of the present embodiment are not inhibited. Any Al compound is converted as a content of Al₂O₃. Note that similar conversion methods are used for other stabilizers and sintering aids, which are expressed in terms of mass% on an oxide basis. Here, although the bending strength is improved when Al₂O₃ is actually contained, and the laser processability is improved when AlN is actually contained, even when AlN is contained, it is converted into Al₂O₃.

### 3. Si₃N₄, BN: 0 to 20%

The ceramic of the present embodiment may contain one or more selected from Si₃N₄ (silicon nitride) and BN (boron nitride).

### Si₃N₄: 0 to 20%

Si₃N₄ is effective in imparting high strength, for example, bending strength, to ceramics. In addition, it also has an effect of improving the laser processability. Therefore, it may be contained as needed. However, when Si₃N₄ is excessively contained, it becomes difficult to obtain a thermal expansion coefficient of 7.0 × 10⁻⁶/°C or more. In addition, the laser processability is also rather reduced. Therefore, the content of Si₃N₄ is preferably 20% or less in terms of mass% on a nitride basis.

The content of Si₃N₄ is more preferably 15% or less. On the other hand, in order to obtain the effects described above, the content of Si₃N₄ is preferably 0.5% or more, preferably 3% or more, more preferably 5% or more, more preferably 7% or more, and further preferably 10% or more in terms of mass% on a nitride basis. Note that, similar to the case of Al₂O₃, also in the case of Si₃N₄, all the compounds containing Si are converted into the content of Si₃N₄, which is a nitride. In the ceramic of the present embodiment, in addition to Si₃N₄, SiC may be contained as a compound that contains Si, but in addition to these compounds, other compounds containing Si may be contained as long as the effects of the ceramic of the present embodiment are not inhibited. Any Si compound is converted as a content of Si₃N₄. The same applies to the case of BN.

### BN: 0 to 20%

BN is effective in imparting the laser processability and the machinability. Therefore, it may be contained as needed. However, when BN is excessively contained, the bending strength is decreased. Therefore, the content of BN is preferably 20% or less in terms of mass% on a nitride basis. In terms of mass% on a nitride basis, the content of BN is more preferably 15% or less, and further preferably 10% or less. On the other hand, in order to obtain the effects described above, the content of BN is preferably 0.5% or more, preferably 3% or more, more preferably 5% or more, more preferably 7% or more, and further preferably 10% or more in terms of mass% on a nitride basis.

### 3. Stabilizer

In order for ZrO₂ to have a cubic crystal structure, it is necessary to contain a compound called a stabilizer. Although Y₂O₃ (also referred to as yttrium oxide, "yttria".) is most common as a stabilizer, in addition to Y₂O₃, there are, for example, CaO (calcium oxide), MgO (also referred to as magnesium oxide, "magnesia".), CeO₂ (cerium oxide), and HfO₂ (hafnium oxide).

The ceramic of the present embodiment contains, in terms of mass% on an oxide basis, one or more selected from Y₂O₃, CaO, MgO, CeO₂, and HfO₂, a total of which is 10 to 30%. Hereinafter, in descriptions, one or more compounds selected from Y₂O₃, CaO, MgO, CeO₂, and HfO₂ are collectively referred to as Group A compound.

When the total content of Group A compound is less than 10% in terms of mass% on an oxide basis, the stabilizer is insufficient, and cubic ZrO₂ is not formed. Therefore, the total content of Group A compound is 10% or more in terms of mass% on an oxide basis. In terms of mass% on an oxide basis, the total content of Group A compound is preferably 12% or more. On the other hand, in terms of mass% on an oxide basis, when the total content of Group A compound is more than 30%, the stabilizer becomes excessive, and a thermal expansion coefficient is likely to be rather decreased. Therefore, the total content of Group A compound is 30% or less in terms of mass% on an oxide basis. In terms of mass% on an oxide basis, the total content of Group A compound is preferably 20% or less, and preferably 18% or less. Note that each compound will be individually described below.

### Y₂O₃

Y₂O₃ is the most common stabilizer and may be contained as needed. In addition, it also acts as a sintering aid as described below. However, when the content of Y₂O₃ is excessive, it becomes rather difficult to obtain a thermal expansion coefficient of 7.0 × 10⁻⁶/°C or more. Therefore, the content of Y₂O₃ is preferably 20% or less in terms of mass% on an oxide basis. On the other hand, in order to obtain the effects as stabilizer described above, the content of Y₂O₃ is preferably 5.4% or more, more preferably 8.0% or more, and further preferably 10% or more in terms of mass% on an oxide basis.

### CaO

Similar to Y₂O₃, CaO is also a stabilizer and may be contained as needed. In addition, it also acts as a sintering aid as described below. However, when the content of CaO is excessive, it becomes rather difficult to obtain a thermal expansion coefficient of 7.0 × 10⁻⁶/°C or more. Therefore, the content of CaO is preferably 20% or less in terms of mass% on an oxide basis. On the other hand, in order to obtain the effects as the stabilizer described above, the content of CaO is preferably 5.4% or more, more preferably 8.0% or more, and further preferably 10% or more in terms of mass% on an oxide basis.

### MgO

Similar to Y₂O₃, MgO is also a stabilizer and may be contained as needed. In addition, it also has the effect of increasing the thermal expansion coefficient. In addition, it also acts as a sintering aid as described below. However, when the content of MgO is excessive, the bending strength is decreased. Therefore, the content of MgO is preferably 20% or less, and more preferably 15% or less in terms of mass% on an oxide basis. On the other hand, in order to obtain the effects as the stabilizer described above, the content of MgO is preferably 5.4% or more, more preferably 8.0% or more, and further preferably 10% or more in terms of mass% on an oxide basis.

### CeO₂

Similar to Y₂O₃, CeO₂ is also a stabilizer and may be contained as needed. In addition, it also acts as a sintering aid as described below. However, when the content of CeO₂ is excessive, it becomes difficult to obtain a thermal expansion coefficient of 7.0 × 10⁻⁶/°C or more. Therefore, the content of CeO₂ is preferably 20% or less in terms of mass% on an oxide basis. On the other hand, in order to obtain the effects as the stabilizer described above, the content of CeO₂ is preferably 5.4% or more, more preferably 8.0% or more, and further preferably 10% or more in terms of mass% on an oxide basis.

### HfO₂

Similar to Y₂O₃, HfO₂ is also a stabilizer and may be contained as needed. In addition, it also acts as a sintering aid as described below. However, when the content of HfO₂ is excessive, it becomes difficult to obtain a thermal expansion coefficient of 7.0 × 10⁻⁶/°C or more. Therefore, the content of HfO₂ is preferably 20% or less in terms of mass% on an oxide basis. On the other hand, in order to obtain the effects as the stabilizer described above, the content of HfO₂ is preferably 5.4% or more, more preferably 8.0% or more, and further preferably 10% or more in terms of mass% on an oxide basis.

### 4. Sintering Aid

The ceramic of the present embodiment may contain the following sintering aids as needed, in addition to each of the components described above. That is, the lower limit of a sintering aid is 0%. Note that sintering aids refer to compounds added in order to facilitate and stabilize sintering of ceramics, and the content of these sintering aids is a value in terms of mass% on an oxide basis.

As sintering aids, there are, for example, TiO₂ (titanium oxide), MoO₃ (molybdenum oxide), Ta₂O₅ (tantalum pentoxide), Yb₂O₃ (ytterbium oxide), and LaO.

Although the content of a sintering aid is not particularly limited, in order to obtain a fine ceramic, it is preferable to contain, for example, 0 to 5% one or more selected from TiO₂, MoO₃, Ta₂O₅, Yb₂O₃, and LaO in terms of mass% on an oxide basis. It is because, when the total content of the compounds is more than 5% in terms of mass% on an oxide basis, the grain boundary phase constituted by low-strength glass or crystals is increased, and the strength is more likely to be decreased.

Note that measurement of the content of each compound is performed, for example, by the following procedures. For example, in the case of the content of ZrO₂, the amount of Zr is identified by using an ICP atomic emission spectrophotometer, and is converted into a value corresponding to oxide to determine the content of ZrO₂. The contents of Al₂O₃, a stabilizer, and a sintering aid are also similarly calculated by converting the amount of each element contained into a value corresponding to oxide. Note that the content of Si₃N₄ or BN is calculated by identifying the amount of Si or B, and converting each identified amount into a value corresponding to nitride.

As an ICP atomic emission spectrophotometer, 5110 manufactured by Agilent Technologies, Inc. was used, measurement was performed three times, and the amount of each element was identified based on the average value. The other measurement conditions may be RF power 1200 W, auxiliary gas flow rate 1 L/min, nebulizer gas flow rate 0.7 L/min, and plasma gas flow rate 12 L/min, and the type of gas may be Ar.

### 5. Characteristics

### 5-1. Thermal Expansion Coefficient

The thermal expansion coefficient of the ceramic of the present embodiment is preferably 7.0 × 10⁻⁶/°C or more. This is for a probe guide to be easily thermally expanded as much as a wafer, even when the wafer is at high temperature, specifically, 125 to 250°C, and a temperature difference occurs between the wafer and the probe guide. The thermal expansion coefficient of the ceramic of the present embodiment is preferably 7.0 to 10 (× 10⁻⁶/°C), and preferably 7.0 to 9.0 (× 10⁻⁶/°C). Note that the upper limit value of the thermal expansion coefficient is not particularly limited, but is preferably set to 1.2 × 10⁻⁵/°C.

The measurement of the thermal expansion coefficient is conducted by performing measurement by using a thermal dilatometer at a heating rate of 5°C/min, and calculating the average linear expansion coefficient at -50 to 200°C. In addition, measurement may be performed based on JIS R 3251:1990.

### 5-2. Thermal Conductivity

When manufacturing a probe guide, it is necessary to form a plurality of through-holes and slits in a material by laser processing or the like. The ease of processing by laser is called laser processability. From the viewpoint of laser processability, the thermal conductivity of the ceramic of the present embodiment is preferably 10 W/m·K or less, more preferably 7 W/m·K or less, and further preferably 5 W/m·K or less. In laser processing, when the thermal conductivity of a workpiece is low, heat transfer to a portion around a laser irradiated portion is inhibited, and it becomes easier to suppress thermal effects, for example, a phenomenon such as fusion, in portions other than a part to be processed. It is because the shape precision is consequently improved. Note that the lower limit of the thermal conductivity is not particularly limited, but is preferably 1.0 W/m·K. The measurement of the thermal conductivity is conducted by performing calculation with the flash method based on JIS R 1611:2010. A thermal constant measuring device may be used for the measurement.

### 5-3. Bending Strength

The bending strength is not particularly limited in the ceramic of the present embodiment. When used for applications such as probe guides, it is preferably, for example, 350 MPa or more, more preferably 400 MPa or more, and further preferably 500 MPa or more. The upper limit of the bending strength is also not particularly limited, but is preferably set to 800 MPa. Note that the bending strength indicates the three-point bending strength, and is calculated based on JIS R 1601:2008.

### 6. Applications

The ceramic of the present embodiment is suitable for, for example, a probe guide component (probe guide), or a probe card including the probe guide component. In addition, the ceramic of the present embodiment is also suitable for a package test socket.

### 7. Manufacturing Method

The ceramic of the present embodiment can be stably manufactured with, for example, a manufacturing method as follows.

The powders of ZrO₂, Group A compound, one or more selected from Al₂O₃, AlN, Si₃N₄, SiC, and BN to be added as needed, and a sintering aid to be added as needed are mixed with a known method such as a ball mill, so that a desired composition is obtained. That is, the respective powders are mixed in a container together with a solvent and a ceramic ball or a resin ball with an iron core to form a slurry. In this case, water or alcohol can be used as the solvent. Furthermore, additives such as a dispersant and a binder may be used as needed.

In addition, although the particle diameter of AlN to be used as a raw material is not particularly limited, since the bending strength varies greatly when the particle diameter is excessively large, the average particle diameter is preferably less than 2 µm. In addition, it is preferable that AlN exist in a dispersed state in the ceramic mainly containing ZrO₂.

Although the particle diameter of Si₃N₄ to be used as a raw material is not particularly limited, since the bending strength varies greatly when the particle diameter is excessively large, the average particle diameter is preferably less than 20 µm, preferably less than 10 µm, more preferably less than 5 µm, and further preferably less than 2 µm. In addition, it is preferable that Si₃N₄ exist in a dispersed state in the ceramic mainly containing ZrO₂. Similarly, although the particle diameter of SiC to be used as a raw material is not particularly restricted, since the volume resistivity varies greatly when the particle diameter is excessively large, it is preferable that the average particle diameter be less than 2 µm. In addition, it is preferable that SiC exist in a dispersed state in the ceramic mainly containing ZrO₂.

Although there are hexagonal system BN (h-BN) and cubic system BN (c-BN) as BN used as a raw material, since c-BN has high hardness, h-BN is preferably used. Although the particle diameter of BN is not particularly limited, since the material strength may be decreased when the particle diameter is excessively large, the average particle diameter is preferably less than 5 µm, and more preferably less than 2 µm.

The obtained slurry is granulated with a known method, such as spray drying and a decompression evaporator. That is, it is spray-dried in a spray drier to be granulated, or is dried in a decompression evaporator to be powdered.

The obtained powder is sintered under high temperature and high pressure with a known method such as hot pressing or HIP (hot isostatic pressing) to obtain a sintered ceramic. In the case of hot pressing, it may be fired in a nitrogen atmosphere or under pressurized nitrogen. In addition, the firing temperature is preferably in the range of 1200 to 1700°C. When the temperature is excessively low, sintering becomes insufficient, and when the temperature is excessively high, problems such as dissolution of oxide components occurs. Note that, in order to increase the bending strength, the firing temperature is preferably lower in the range described above.

The pressurizing force is suitably in the range of 15 to 35 MPa. Note that, in order to increase the thermal expansion coefficient, the pressurizing force is preferably higher in the range described above. In addition, the duration of the pressurizing force depends on the temperature and the dimensions, but is normally about 1 to 3 hours. In addition, also in the case of HIP, the firing conditions, such as the temperature and the pressurizing force, may be set appropriately. Furthermore, a known firing method, such as atmospheric pressure firing or atmospheric pressure firing, may be employed.

Hereinafter, although a ceramic according to the present invention will be more specifically described with examples, the present embodiment is not limited to these examples.

### EXAMPLES

Powder raw materials having the ratios shown in Table 1 were prepared. Note that ZrO₂ containing in advance 5.4 mass% Y₂O₃ as a stabilizer was used.

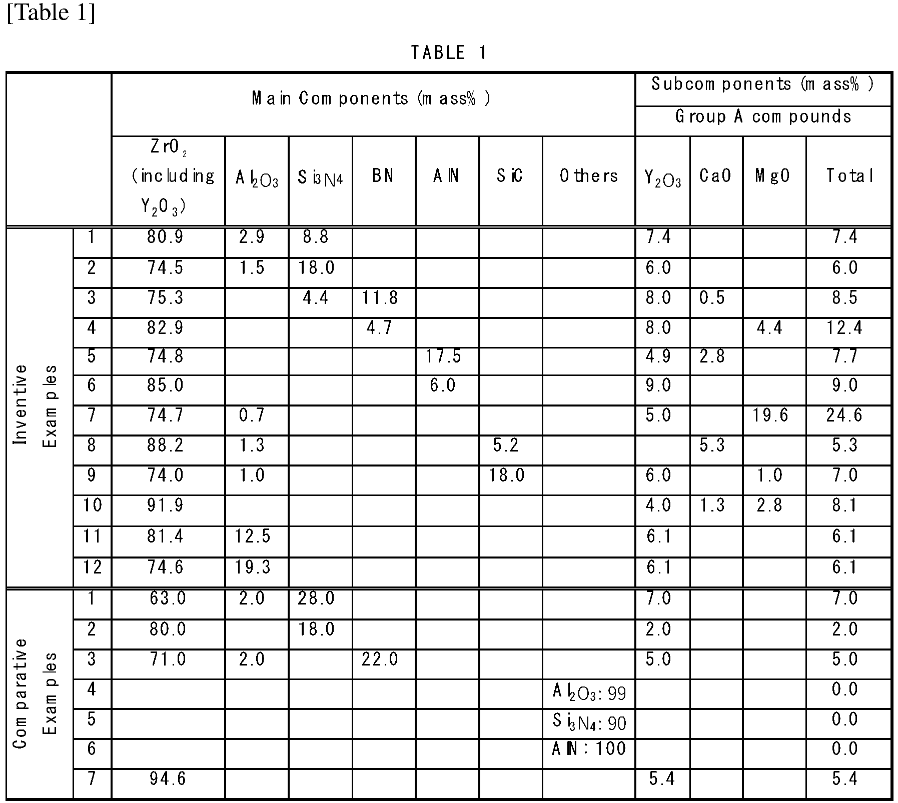

The powder raw materials were mixed with water, a dispersant, a resin, and a ceramic ball, and the obtained slurry was spray-dried in a spray drier to be granulated. The obtained granules were filled into a graphite die (mold), and hot press firing was performed for 2 hours in the range of 1300 to 1700°C according to the raw materials, while applying a pressure of 30 MPa in a nitrogen atmosphere to obtain a test material with a length of 150 × a width of 150 × a thickness of 30 mm. A test specimen was taken from the obtained test material, and various kinds of tests were performed. In addition, the content of the obtained test specimen was measured by using the ICP atomic emission spectrophotometer.

### <Each Content>

The content of ZrO₂ was obtained by identifying the amount of Zr in the test specimen, and converting this amount into a value corresponding to oxide. The content of Al₂O₃ was obtained by identifying the amount of Al in the test specimen, and converting this amount into a value corresponding to oxide. Moreover, the contents of a stabilizer and a sintering aid were also similarly obtained by converting the amount of each element contained into a value corresponding to oxide. Note that the content of Si₃N₄ or BN was obtained by identifying the amount of Si or B, and converting each identified amount into a value corresponding to nitride.

As an ICP atomic emission spectrophotometer, 5110 manufactured by Agilent Technologies, Inc. was used, measurement was performed three times, and the amount of each element was identified based on the average value. The other measurement conditions were RF power 1200 W, auxiliary gas flow rate 1 L/min, nebulizer gas flow rate 0.7 L/min, and plasma gas flow rate 12 L/min, and the type of gas was Ar. The chemical compositions are summarized and shown below in Table 2. In addition, the crystal structures were also measured and written by the following procedures.

### <Crystal Structure of ZrO₂>

The peak intensity was measured by XRD, and the peak intensity of each crystal phase (monoclinic, cubic, and tetragonal) on the (200) plane of ZrO₂ was obtained. 34.2 degrees is the monoclinic peak, 34.9 degrees is the cubic peak, and 35.3 degrees is the tetragonal peak. In addition, when the sum of the three peak intensities was 100%, in a case where the cubic peak intensity was 80% or more, it was determined that the crystal structure of ZrO₂ was cubic. Note that, in order to remove noise during measurement, the peak intensity was obtained by drawing a baseline in the range of diffraction angle 2θ of 32 to 38 degrees. Note that an XRD manufactured by Bruker Corporation was used for measurement. In addition, in the table, OK was written in those whose crystal structures were determined to be cubic, and NG was written in those whose crystal structures were not determined to be cubic.

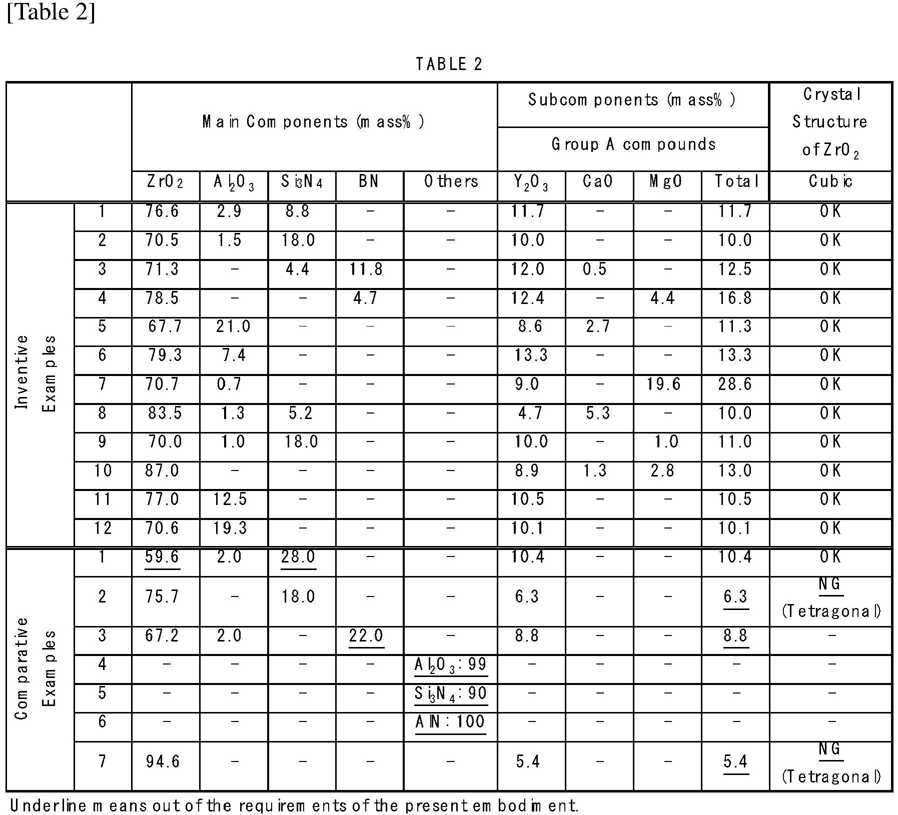

Each of the characteristics described below was examined by using each test material.

### <Thermal Expansion Coefficient>

The thermal expansion coefficient was measured by performing measurement by using a thermal dilatometer at a heating rate of 5°C/min, and calculating the average linear expansion coefficient at -50 to 200°C. In addition, measurement was performed based on JIS R 3251:1990.

### <Bending Strength>

The three-point bending strength was obtained based on JIS R 1601:2008.

### <Relative Density>

The bulk density of the test material was obtained according to JIS C 2141:1992, and the obtained bulk density was divided by the theoretical density to obtain the relative density. A relative density of 90% or more is determined to be good.

### <Thermal Conductivity>

The thermal conductivity was obtained with the flash method based on JIS R 1611:2010. A thermal constant measuring device was used for the measurement.

### <Laser Processability>

In order to evaluate the actual laser processability, as illustrated in Figure 4, laser processing was performed to form four square shapes each having 50 µm on all sides (a depth of 0.038 mm). Note that Figure 4 is a schematic diagram of a surface subjected to laser processing as viewed from a laser incidence direction. In this schematic diagram, a laser exit side and a laser entrance side overlap. When the laser processability is poor, while processing the squares on a lower surface first (the laser exit side), an upper surface (the laser entrance side) is also laser processed, and the dimensional accuracy is decreased. Therefore, when evaluating the laser processability, dimensional variations were evaluated, that is, the average value of the vertical lengths and the horizontal lengths of the laser processed portions (the average value of a total of 32 sides) was obtained to evaluate the dimensional variations. When the dimensional variation was 10 µm or less, the laser processability was determined to be good. The results are summarized and shown below in Table 3.

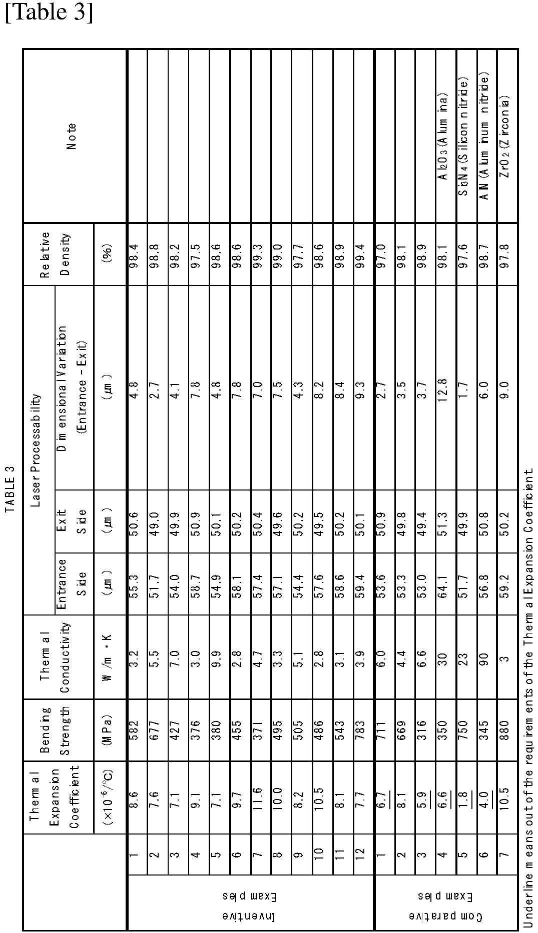

In Inventive Examples 1 to 12 that satisfy the requirements of the present embodiment, the thermal expansion coefficient was 7.0 × 10⁻⁶/°C or more, and the crystal structure of ZrO₂ was also cubic. Therefore, the thermal expansion coefficient is good, and dimensional changes can also be suppressed. On the other hand, in Comparative Examples 1 to 7 that do not satisfy the requirements of the present embodiment, the thermal expansion coefficient is low, or a lot of non-cubic ZrO₂ was formed.

### [Appendix]

(1) A ceramic having a chemical composition containing,
   in terms of mass% on an oxide basis,
   66.5% or more ZrO₂, and
   one or more selected from Y₂O₃, CaO, MgO, CeO₂, and HfO₂, a total of which is 10 to 30%, wherein
   a crystal structure of the ZrO₂ is cubic.
(2) The ceramic according to (1) described above, wherein the chemical composition further contains,
   in terms of mass% on an oxide basis,
   Al₂O₃: 0 to 25%, and
   further contains, in terms of mass% on a nitride basis,
   Si₃N₄: 0 to 20%, and
   BN: 0 to 20%.
(3) The ceramic according to (1) or (2) described above, wherein the chemical composition further contains,
   in terms of mass% on an oxide basis,
   0 to 5% one or more selected from TiO₂, MoO₃, Ta₂O₅, Yb₂O₃, and LaO.
(4) The ceramic according to any of (1) to (3) described above, wherein a thermal expansion coefficient is 7.0 × 10⁻⁶/°C or more.
(5) The ceramic according to any of (1) to (4) described above, wherein a thermal conductivity is 10 W/m·K or less.
(6) A probe guide component including the ceramic according to any of (1) to (5) described above.
(7) A probe card including the probe guide component according to (6) described above.
(8) A package test socket including the ceramic according to any of (1) to (5) described above.

### REFERENCE SIGNS LIST

10. Probe card
11. Probe
12. Probe guide (probe guide component)
12a. Through hole
13. Silicon wafer
14. IC chip

## Claims

1. A ceramic having a chemical composition containing,
in terms of mass% on an oxide basis,
66.5% or more ZrO₂, and
one or more selected from Y₂O₃, CaO, MgO, CeO₂, and HfO₂, a total of which is 10 to 30%, wherein
a crystal structure of the ZrO₂ is cubic.

2. The ceramic according to claim 1, wherein the chemical composition further contains,
in terms of mass% on an oxide basis,
Al₂O₃: 0 to 25%, and
further contains, in terms of mass% on a nitride basis,
Si₃N₄: 0 to 20%, and
BN: 0 to 20%.

3. The ceramic according to claim 1, wherein the chemical composition further contains,
in terms of mass% on an oxide basis,
0 to 5% one or more selected from TiO₂, MoO₃, Ta₂O₅, Yb₂O₃, and LaO.

4. The ceramic according to claim 2, wherein the chemical composition further contains,
in terms of mass% on an oxide basis,
0 to 5% one or more selected from TiO₂, MoO₃, Ta₂O₅, Yb₂O₃, and LaO.

5. The ceramic according to any of claims 1 to 4, wherein a thermal expansion coefficient is 7.0 × 10⁻⁶/°C or more.

6. The ceramic according to any of claims 1 to 4, wherein a thermal conductivity is 10 W/m·K or less.

7. The ceramic according to claim 5, wherein a thermal conductivity is 10 W/m·K or less.

8. A probe guide component including the ceramic according to any of claims 1 to 4.

9. A probe card including the probe guide component according to claim 8.

10. A package test socket including the ceramic according to any of clams 1 to 4.
